# EUROPÄISCHE PATENTSCHRIFT

(11) **EP 1 543 567 B1**
(45) Veröffentlichungstag und Bekanntmachung des Hinweises auf die Patenterteilung: **02.04.2008**
(21) Anmeldenummer: 03798073.7
(22) Anmeldetag: 22.09.2003
(51) Int. Cl.: H01L 33/00

(54) **STRAHLUNGSEMITTIERENDES HALBLEITERBAUELEMENT**
RADIATION-EMITTING SEMICONDUCTOR COMPONENT
COMPOSANT A SEMICONDUCTEURS EMETTANT UN RAYONNEMENT

(30) Priorität: 23.09.2002 DE 10244200
(43) Veröffentlichungstag der Anmeldung: 22.06.2005
(73) Patentinhaber: OSRAM Opto Semiconductors GmbH, 93055 Regensburg (DE)
(72) Erfinder: BAUR, Johannes, 93051 Regensburg (DE); EISERT, Dominik, 93049 Regensburg (DE); FEHRER, Michael, 93077 Bad Abbach (DE); HAHN, Berthold, 93155 Hemau (DE); PLÖSSL, Andreas, 93051 Regensburg (DE); STEIN, Wilhelm, 88131 Lindau (DE)
(74) Vertreter: Epping - Hermann - Fischer
(86) Internationale Anmeldenummer: PCT/DE2003/003147
(87) Internationale Veröffentlichungsnummer: WO 2004/030108

(56) Entgegenhaltungen:
- EP-A- 0 607 435
- EP-A- 1 168 460
- WO-A-01/47038
- WO-A-01/47039
- DE-A- 10 017 336
- US-A1- 2002 081 800
- PATENT ABSTRACTS OF JAPAN Bd. 1999, Nr. 13, 30. November 1999 (1999-11-30) & JP 11 220168 A (TOYODA GOSEI CO LTD), 10. August 1999 (1999-08-10)
- PATENT ABSTRACTS OF JAPAN Bd. 1999, Nr. 11, 30. September 1999 (1999-09-30) & JP 11 150302 A (NICHIA CHEM IND LTD), 2. Juni 1999 (1999-06-02)
- MINAMINO Y ET AL: "Amorphous Si solar cell on ceramic substrate" IEEE PHOTOVOLTAIC SPECIALISTS CONF, Bd. VOL. 1, 1. Mai 1984 (1984-05-01), Seiten 229-234, XP000014038

## Beschreibung

Die Erfindung betrifft ein strahlungsemittierendes Halbleiterbauelement gemäß Oberbegriff des Patentanspruches 1.

Sie betrifft insbesondere ein strahlungsemittierendes Halbleiterbauelement mit einer Schichtstruktur, die eine Photonen emittierende aktive Schicht, eine n-dotierte Mantelschicht und eine p-dotierte Mantelschicht enthält, einem mit der n-dotierten Mantelschicht verbundenen n-Kontakt und einer mit der p-dotierten Mantelschicht verbundenen Spiegelschicht.

Für den Einsatz bei strahlungsemittierenden Halbleiterbauelementen, wie etwa InGaN-basierten Top-Down montierten Lumineszenzdioden oder Dünnfilm-Lumineszenzdioden sind hochreflektierende Spiegelmaterialien erforderlich, die eine von der aktiven Zone zur Bauelementrückseite hin ausgesandte Strahlung wieder zur Vorderseite hin oder zu den Bauelementflanken hin reflektieren.

Bei Top-Down montierten Lumineszenzdioden ist die strahlungserzeugende Epitaxieschichtenfolge zur Montageseite hin gewandt, das heißt, das Bauelement strahlt, falls noch vorhanden, durch das Aufwachssubstrat ab. Bei Dünnfilm-Lumineszenzdioden ist das Aufwachssubstrat zum epitaktischen Aufwachsen der strahlungserzeugenden Epitaxieschichtenfolge zumindest teilweise entfernt und die Epitaxieschichtenfolge befindet sich auf einem nachträglich aufgebrachten Trägersubstrat.

Für Lumineszenzdioden auf Basis Nitrid-III-V-Verbindungshalbleitermaterial, insbesondere auf der Basis von GaN, wie AlGaN, InGaN und InGaAlN sowie auch GaN selbst, sollen die Spiegelmaterialien darüber hinaus einen ohmschen Kontakt zur p-dotierten Schicht der Schichtstruktur bilden.

Dabei besteht das Problem, daß im blauen Spektralbereich gut reflektierende Metalle wie Aluminium keinen ohmschen Kontakt auf p-GaN oder dazu verwandten Materialien, wie p-AlGaN, p-InGaN und p-InGaAlN bilden. Andererseits sind Materialien, die einen guten Kontakt auf p-GaN usw. bilden, wie etwa Platin oder Palladium, im blauen Spektralbereich absorbierend und daher als Spiegelmaterial nicht geeignet. Lediglich Silber ist sowohl in ausreichendem Maß reflektierend als auch zur Kontaktierung von p-GaN usw. geeignet. Allerdings besteht hier der Nachteil, daß die mechanische Stabilität von Silberschichten in Lumineszenzdioden ungenügend ist.

WO 01/47038 A1 offenbart eine Leuchtdiode auf Nitrud-III-V Basis mit einem mehrschichtigen, reflektierenden ohmschen Kontakt, bestehend aus einer ohmschen Kontaktschicht und einer Spiegelschicht aus Ag, Al, Cu, Rh, Au oder Pd.

Unter die Gruppe von strahlungsemittierenden Bauelementen auf Basis von Nitrid-III-V-Verbindungshalbleitermaterial fallen vorliegend insbesondere solche Chips, bei denen die epitaktisch hergestellte Halbleiterschicht, die in der Regel eine Schichtfolge aus unterschiedlichen Einzelschichten aufweist, mindestens eine Einzelschicht enthält, die ein Material aus dem Nitrid-III-V-Verbindungshalbleitermaterial-System InₓAl_{y}-Ga_{1-x-y}N mit 0 ≤ x ≤ 1, 0 ≤ y ≤ 1 und x+y ≤ 1 aufweist. Die Halbleiterschicht kann beispielsweise einen herkömmlichen pn-Übergang, eine Doppelheterostruktur, eine Einfach-Quantentopfstruktur (SQW-Struktur) oder eine Mehrfach-Quantentopfstruktur (MQW-Strukur) aufweisen. Solche Strukturen sind dem Fachmann bekannt und werden von daher an dieser Stelle nicht näher erläutert.

Auch bei kurzwelligen auf InGaAlP basierenden Dünnfilm-Lumineszenzdioden ist die Wahl des Spiegelmaterials schwierig. Gold, das gegenwärtig oft als Spiegelmaterial verwendet wird, begrenzt aufgrund seiner vergleichsweise geringen Re-flektivität die Effizienz dieser Dioden. Das vom Standpunkt der Reflektivität her besser geeignete Silber wurde bisher wegen seiner mangelnden Haftung und aufgrund von Migrationsproblemen nicht verwendet.

DE 10017336 A1 offenbart eine Leuchtdiode auf Phosphid-III-V Basis mit einer Spiegelschicht aus Ag, Au, Zn, Ge, Ni oder Mischungen daraus.

Ein Ansatz zur Behebung dieser Schwierigkeiten besteht darin, Aluminiumspiegel zu verwenden, bei denen der elektrische Anschluß durch eine Platinschicht gebildet wird und die optischen Eigenschaften durch das Aluminium gegeben sind. Alternativ kann Silber abgeschieden werden, das durch weitere Metalle an der waferabgewandten Seite fixiert wird.

Der vorliegenden Erfindung liegt die Aufgabe zugrunde, ein strahlungsemittierendes Halbleiterbauelement der eingangs genannten Art mit einer verbesserten Spiegelschicht anzugeben und so die Effizienz und die Leistungsfähigkeit dieser Bauelemente zu steigern.

Diese Aufgabe wird durch ein strahlungsemittierendes Halbleiterbauelement mit den Merkmalen des Patentanspruches 1 gelöst. Vorteilhafte Ausgestaltungen und Weiterbildungen sind in den Unteransprüchen 2 bis 13 angegeben.

Erfindungsgemäß ist bei einem gattungsgemäßen strahlungsemittierenden Halbleiterbauelement die Spiegelschicht durch eine Legierung von Silber mit einem oder mehreren Metallen der Gruppe Ru, Rh, Pd, Au, Os, Ir, Pt, Cu, Ti, Ta und Cr gebildet. Durch Zumischung dieser Metalle können die mechanischen Eigenschaften von Silberschichten wesentlich verbessert werden, ohne die Reflektivität der Schicht im Vergleich zu reinem Silber zu vermindern. Zugleich wird die Diffusion von Silber in die angrenzende Halbleiterschicht verringert.

In einer bevorzugten Ausgestaltung des erfindungsgemäßen strahlungsemittierenden Halbleiterbauelements ist die Spiegelschicht durch eine Legierung von Silber mit einem Metallen der Gruppe Ru, Rh, Pd, Au, Os, Ir, Pt und einem Metallen der Gruppe Cu, Ti, Ta, Cr gebildet. Derartige ternäre Legierungen weisen sowohl hohe Reflektivität im gewünschten kurzwelligen Spektralbereich als auch eine ausreichende mechanische Stabilität auf.

Als besonders bevorzugt wird angesehen, wenn die Spiegelschicht durch eine Ag-Pt-Cu-Legierung gebildet ist. Diese Legierung vereint eine hohe Reflektivität im blauen Spektralbereich mit einer hohen mechanischen und thermischen Stabilität.

Mit Vorteil ist in diesem Zusammenhang vorgesehen, daß die Legierung der Spiegelschicht neben Silber insgesamt 0,1 Gew-% bis 15 Gew-%, bevorzugt 1 Gew-% bis 5 Gew-% der genannten Metalle umfaßt.

In einer bevorzugten Weiterbildung des erfindungsgemäßen strahlungsemittierenden Halbleiterbauelements ist vorgesehen, daß die Legierung der Spiegelschicht neben Silber 0,5 bis 5 Gew-% von einem oder mehreren Metallen der Gruppe Ru, Rh, Pd, Au, Os, Ir, Pt und 0,5 bis 5 Gew-% von einem oder mehreren Metallen der Gruppe Cu, Ti, Ta, Cr umfaßt.

Insbesondere umfaßt dabei die Legierung der Spiegelschicht des strahlungsemittierenden Halbleiterbauelements neben Silber 1 bis 3 Gew-% Platin und 1 bis 3 Gew-% Kupfer.

In einer zweckmäßigen Weiterbildung der Erfindung bildet die Spiegelschicht mit der p-dotierten Mantelschicht einen ohmschen Kontakt, so daß die Spiegelschicht zugleich die Funktion einer p-Kontaktschicht übernehmen kann.

Besonders geeignet ist die erfindungsgemäße Ausgestaltung der Spiegelschicht für den Einsatz in strahlungsemittierenden Halbleiterchips, insbesondere Dünnfilm-Leuchtdioden-Chips, in denen die strahlungserzeugende Schichtstruktur auf Basis von InGaAlN oder InGaAlP gebildet ist. Insbesondere können bei InGaAIN-basierten Lumineszenzdioden mit silberhaltigen Legierungen ohmsche Kontakte hergestellt werden. Somit kann die Spiegelmetallisierung direkt über einer lichterzeugenden Schichtstruktur hergestellt werden.

Ein Dünnfilm-Leuchtdioden-Chip zeichnet sich insbesondere durch folgende charakteristische Merkmale aus:
- an einer zu einem Trägerelement hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20µm oder weniger, insbesondere im Bereich von 10 µm auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben.

Ein Dünnfilm-Leuchtdioden-Chip ist in guter Näherung ein Lambert' scher Oberflächenstrahler und eignet sich von daher besonders gut für die Anwendung in einem Scheinwerfer.

"Strahlungserzeugende Schichtstruktur auf Basis von InGaAlP" bedeutet in diesem Zusammenhang, dass eine derart bezeichnete Schichtstruktur oder Teil einer solchen Schichtstruktur vorzugsweise AlₙGaₘIn₁₋ₙ₋ₘP umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern.

"Strahlungserzeugende Schichtstruktur auf Basis von InGaAlN" bedeutet in diesem Zusammenhang, dass eine derart bezeichnete Schichtstruktur oder Teil einer solchen Schichtstruktur vorzugsweise AlₙGaₘIn₁₋ₙ₋ₘN umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern.

Weitere vorteilhafte Ausgestaltungen, Merkmale und Details der Erfindung ergeben sich aus den abhängigen Ansprüchen, der Beschreibung des Ausführungsbeispiels und der Zeichnung.

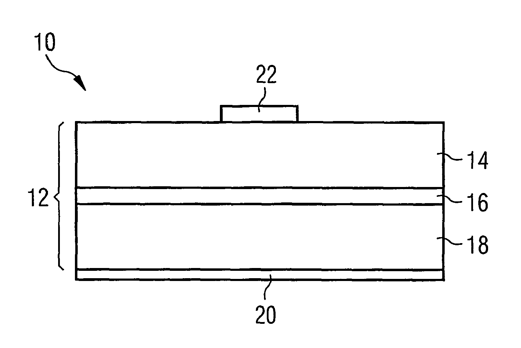

Die Erfindung wird nachfolgend anhand eines Ausführungsbeispiels im Zusammenhang mit der Zeichnung näher erläutert. Es sind jeweils nur die für das Verständnis der Erfindung wesentlichen Elemente dargestellt. Dabei zeigt
- Figur 1: eine schematische Schnittansicht eines strahlungsemittierenden Halbleiterbauelements nach einem Ausführungsbeispiel der Erfindung.

Figur 1 zeigt in schematischer Schnittansicht eine im blauen Spektralbereich emittierende InGaN-Lumineszenzdiode 10. Die Lumineszenzdiode 10 enthält eine Schichtstruktur 12, die eine n-dotierte Mantelschicht 14, eine Photonen emittierende aktive Schicht 16, und eine p-dotierte Mantelschicht 18 aufweist.

Auf der n-dotierten Mantelschicht 14 ist zur Stromzuführung ein n-Kontakt 22 angeordnet. Der p-Kontakt wird im Ausführungsbeispiel durch die p-Kontaktschicht 20 gebildet, welche zugleich eine hochreflektierende Spiegelschicht darstellt, die den von der aktiven Schicht 16 in Richtung der Spiegelschicht emittierten Anteil der erzeugten Strahlung reflektiert.

Die Spiegelschicht 20 besteht im Ausführungsbeispiel aus einer AgPtCu-Legierung mit einem Anteil von etwa 1,5 Gew-% Platin und etwa 1,5 Gew-% Kupfer. Diese Legierung bildet einerseits einen guten ohmschen Kontakt mit der p-GaN-Mantelschicht 18. Andererseits werden durch die Zumischung von Platin und Kupfer zu Silber die mechanischen Eigenschaften der Silberschicht deutlich verbessert. Die hohe Reflektivität der Spiegelschicht im blauen Spektralbereich bleibt dabei erhalten. Darüber hinaus tritt kaum Diffusion von Silberatomen aus der AgPtCu-Schicht 20 in die p-dotierte Mantelschicht 18 auf, so daß im Ergebnis eine hochreflektierende stabile p-Kontaktschicht erhalten wird.

Eine derartige Spiegelschicht aus einer AgPtCu-Legierung ist darüber hinaus auch für den Einsatz in InGaAlP Dünnfilm-Lumineszenzdioden geeignet, wo sie als hochreflektierender und thermisch stabiler Metallspiegel zur Steigerung der Effizienz der LEDs beiträgt.

Alternativ kann die Spiegelschicht aus einer AgPtRhCu-, einer AgPtCuTi- oder einer AgPtRhCuTi-Legierung oder einer anderen der vorteilhaften Legierungen, wie sie im allgemeinen Teil der Beschreibung genannt sind, bestehen.

## Patentansprüche

1. Strahlungsemittierendes Halbleiterbauelement mit
- einer Schichtstruktur (12), die mindestens eine Photonen emittierende aktive Zone (16) aufweist, die zwischen einer n-leitend dotierten Mantelschicht (14) und einer p-leitend dotierten Mantelschicht (18) angeordnet ist,
- einem mit der n-leitend dotierten Mantelschicht (14) verbundenen n-Kontakt, und
- einer an der von der aktiven Zone (16) abgewandten Seite der p-leitend dotierten Mantelschicht (18) angeordneten Spiegelschicht (20),
**dadurch gekennzeichnet, daß**
die Spiegelschicht (20) durch eine Legierung von Silber mit einem oder mehreren Metallen der Gruppe Ru, Os, Ir, Cu, Ti, Ta und Cr gebildet ist.

2. Strahlungsemittierendes Halbleiterbauelement nach Anspruch 1, **dadurch gekennzeichnet, daß** die Spiegelschicht (20) durch eine zumindest ternäre Legierung von Silber mit einem oder mehreren Metallen der Gruppe Ru, Rh, Pd, Au, Os, Ir, Pt und einem oder mehreren Metallen der Gruppe Cu, Ti, Ta, Cr gebildet ist.

3. Strahlungsemittierendes Halbleiterbauelement nach Anspruch 1, **dadurch gekennzeichnet, daß** die Spiegelschicht (20) durch eine zumindest ternäre Legierung von Silber mit einem Metall der Gruppe Ru, Rh, Pd, Au, Os, Ir, Pt und einem oder mehreren Metallen der Gruppe Cu, Ti, Ta, Cr gebildet ist.

4. Strahlungsemittierendes Halbleiterbauelement nach Anspruch 1, **dadurch gekennzeichnet, daß** die Spiegelschicht (20) durch eine zumindest ternäre Legierung von Silber mit einem oder mehreren Metallen der Gruppe Ru, Rh, Pd, Au, Os, Ir, Pt und einem Metall der Gruppe Cu, Ti, Ta, Cr gebildet ist.

5. Strahlungsemittierendes Halbleiterbauelement nach Anspruch 1, **dadurch gekennzeichnet, daß** die Spiegelschicht (20) durch eine ternäre Legierung von Silber mit einem Metall der Gruppe Ru, Rh, Pd, Au, Os, Ir, Pt und einem Metall der Gruppe Cu, Ti, Ta, Cr gebildet ist.

6. Strahlungsemittierendes Halbleiterbauelement nach Anspruch 1, **dadurch gekennzeichnet, daß** die Spiegelschicht (20) durch eine Ag-Pt-Cu-Legierung gebildet ist.

7. Strahlungsemittierendes Halbleiterbauelement nach einem der vorhergehenden Ansprüche,
**dadurch gekennzeichnet, daß** die Legierung der Spiegelschicht (20) neben Silber insgesamt 0,1 Gew-% bis 15 Gew-%, bevorzugt 1 Gew-% bis 5 Gew-% der genannten Metalle umfaßt.

8. Strahlungsemittierendes Halbleiterbauelement nach einem der Ansprüche 2 bis 5,
**dadurch gekennzeichnet, daß** die Legierung der Spiegelschicht (20) neben Silber 0,5 bis 5 Gew-% von einem oder mehreren Metallen der Gruppe Ru, Rh, Pd, Au, Os, Ir, Pt und 0,5 bis 5 Gew-% von einem oder mehreren Metallen der Gruppe Cu, Ti, Ta, Cr umfaßt.

9. Strahlungsemittierendes Halbleiterbauelement nach Anspruch 6, **dadurch gekennzeichnet, daß** die Legierung der Spiegelschicht (20) neben Silber 1 bis 3 Gew-% Platin und 1 bis 3 Gew-% Kupfer umfaßt.

10. Strahlungsemittierendes Halbleiterbauelement nach einem der vorhergehenden Ansprüche,
**dadurch gekennzeichnet, daß** die Spiegelschicht (20) mit der p-leitend dotierten Mantelschicht (18) oder mit einer zwischen ihr und der Mantelschicht (18) angeordneten weiteren p-leitend dotieren Halbleiterschicht einen ohmschen Kontakt bildet.

11. Strahlungsemittierendes Halbleiterbauelement nach einem der vorhergehenden Ansprüche,
**dadurch gekennzeichnet, daß** die Schichtstruktur (12) auf Basis von Nitrid-III-V-Verbindungshalbleitermaterial gebildet ist.

12. Strahlungsemittierendes Halbleiterbauelement nach Anspruch 11,
**dadurch gekennzeichnet, daß** die Schichtstruktur (12) auf Basis von InGaAlN gebildet ist.

13. Strahlungsemittierendes Halbleiterbauelement nach einem der Ansprüche 1 bis 10,
**dadurch gekennzeichnet, daß** die Schichtstruktur (12) auf Basis von Phosphid-III-V-Verbindungshalbleitermaterial gebildet ist.

14. Strahlungsemittierendes Halbleiterbauelement nach Anspruch 13,
**dadurch gekennzeichnet, daß** die Schichtstruktur (12) auf Basis von InGaAlP gebildet ist.

## Claims

1. Radiation-emitting semiconductor component, having
- a layer structure (12) which includes at least one photon-emitting active zone (16) arranged between a cladding layer (14) that is n-conductively doped and a cladding layer (18) that is p-conductively doped,
- an n-type contact connected to the cladding layer (14) that is n-conductively doped, and
- a mirror layer (20) arranged on the side, remote from the active zone (16), of the cladding layer (18) that is p-conductively doped,
**characterized in that**
the mirror layer (20) is formed by an alloy of silver with one or more metals selected from the group consisting of Ru, Os, Ir, Cu, Ti, Ta and Cr.

2. Radiation-emitting semiconductor component according to Claim 1, **characterized in that** the mirror layer (20) is formed by an at least ternary alloy of silver with one or more metals selected from the group consisting of Ru, Rh, Pd, Au, Os, Ir, Pt and one or more metals selected from the group consisting of Cu, Ti, Ta, Cr.

3. Radiation-emitting semiconductor component according to Claim 1, **characterized in that** the mirror layer (20) is formed by an at least ternary alloy of silver with a metal selected from the group consisting of Ru, Rh, Pd, Au, Os, Ir, Pt and one or more metals selected from the group consisting of Cu, Ti, Ta, Cr.

4. Radiation-emitting semiconductor component according to Claim 1, **characterized in that** the mirror layer (20) is formed by an at least ternary alloy of silver with one or more metals selected from the group consisting of Ru, Rh, Pd, Au, Os, Ir, Pt and a metal selected from the group consisting of Cu, Ti, Ta, Cr.

5. Radiation-emitting semiconductor component according to Claim 1, **characterized in that** the mirror layer (20) is formed by a ternary alloy of silver with a metal selected from the group consisting of Ru, Rh, Pd, Au, Os, Ir, Pt and a metal selected from the group consisting of Cu, Ti, Ta, Cr.

6. Radiation-emitting semiconductor component according to Claim 1, **characterized in that** the mirror layer (20) is formed by an Ag-Pt-Cu alloy.

7. Radiation-emitting semiconductor component according to one of the preceding claims, **characterized in that** the alloy of the mirror layer (20), in addition to silver, comprises a total of 0.1% by weight to 15% by weight, preferably 1% by weight to 5% by weight, of the abovementioned metals.

8. Radiation-emitting semiconductor component according to one of Claims 2 to 5, **characterized in that** the alloy of the mirror layer (20), in addition to silver, comprises 0.5 to 5% by weight of one or more metals selected from the group consisting of Ru, Rh, Pd, Au, Os, Ir, Pt and 0.5 to 5% by weight of one or more metals selected from the group consisting of Cu, Ti, Ta, Cr.

9. Radiation-emitting semiconductor component according to Claim 6, **characterized in that** the alloy of the silver layer (20), in addition to silver, comprises 1 to 3% by weight of platinum and 1 to 3% by weight of copper.

10. Radiation-emitting semiconductor component according to one of the preceding claims, **characterized in that** the mirror layer (20) forms an ohmic contact with the cladding layer (18) that is p-conductively doped or with a further semiconductor layer that is p-conductively doped and is arranged between it and the cladding layer (18).

11. Radiation-emitting semiconductor component according to one of the preceding claims, **characterized in that** the layer structure (12) is based on nitride III-V compound semiconductor material.

12. Radiation-emitting semiconductor component according to Claim 11, **characterized in that** the layer structure (12) is based on InGaAlN.

13. Radiation-emitting semiconductor component according to one of Claims 1 to 10, **characterized in that** the layer structure (12) is based on phosphide III-V compound semiconductor material.

14. Radiation-emitting semiconductor component according to Claim 13, **characterized in that** the layer structure (12) is based on InGaAlP.

## Revendications

1. Composant semi-conducteur émetteur de rayonnement, qui présente :
- une structure stratifiée (12) qui présente au moins une zone active (16) émettrice de photons, disposée entre une couche d'enveloppe (14) dopée négativement et une couche d'enveloppe (18) dopée positivement,
- un contact négatif relié à la couche d'enveloppe (14) dopée négativement,
- une couche réfléchissante (20) disposée sur le côté de la couche d'enveloppe (18) dopée positivement non tourné vers la zone active (16),
**caractérisé en ce que**
la couche réfléchissante (20) est formée d'un alliage d'argent avec un ou plusieurs métaux de l'ensemble constitué par Ru, Os, Ir, Cu, Ti, Ta et Cr.

2. Composant semi-conducteur émetteur de rayonnement selon la revendication 1, **caractérisé en ce que** la couche réfléchissante (20) est formée d'un alliage au moins ternaire d'argent avec un ou plusieurs métaux de l'ensemble constitué de Ru, Rh, Pd, Au, Os, Ir et Pt, et d'un ou plusieurs métaux de l'ensemble constitué de Cu, Ti, Ta et Cr.

3. Composant semi-conducteur émetteur de rayonnement selon la revendication 1, **caractérisé en ce que** la couche réfléchissante (20) est formée d'un alliage au moins ternaire d'argent avec un métal de l'ensemble constitué de Ru, Rh, Pd, Au, Os, Ir et Pt, et d'un ou plusieurs métaux de l'ensemble constitué de Cu, Ti, Ta et Cr.

4. Composant semi-conducteur émetteur de rayonnement selon la revendication 1, **caractérisé en ce que** la couche réfléchissante (20) est formée d'un alliage au moins ternaire d'argent et d'un ou plusieurs métaux de l'ensemble constitué de Ru, Rh, Pd, Au, Os, Ir et Pt, et d'un métal de l'ensemble constitué de Cu, Ti, Ta et Cr.

5. Composant semi-conducteur émetteur de rayonnement selon la revendication 1, **caractérisé en ce que** la couche réfléchissante (20) est formée d'un alliage ternaire d'argent avec un métal de l'ensemble constitué de Ru, Rh, Pd, Au, Os, Ir et Pt, et d'un métal de l'ensemble constitué de Cu, Ti, Ta et Cr.

6. Composant semi-conducteur émetteur de rayonnement selon la revendication 1, **caractérisé en ce que** la couche réfléchissante (20) est formée d'un alliage d'Ag, Pt et Cu.

7. Composant semi-conducteur émetteur de rayonnement selon l'une des revendications précédentes, **caractérisé en ce qu'**en plus d'argent, l'alliage de la couche d'argent (20) contient globalement de 0,1 % en poids à 15 % en poids et de préférence de 1 % en poids à 5 % en poids desdits métaux.

8. Composant semi-conducteur émetteur de rayonnement selon l'une des revendications 2 à 5, **caractérisé en ce qu'**en plus d'argent, l'alliage de la couche réfléchissante (20) contient de 0,5 à 5 % en poids d'un ou plusieurs des métaux de l'ensemble constitué de Ru, Rh, Pd, Au, Os, Ir et Pt, et de 0,5 à 5 % en poids d'un ou plusieurs des métaux de l'ensemble constitué de Cu, Ti, Ta et Cr.

9. Composant semi-conducteur émetteur de rayonnement selon la revendication 6, **caractérisé en ce qu'**en plus d'argent, l'alliage de la couche réfléchissante (20) contient de 1 à 3 % de platine et de 1 à 3 % en poids de cuivre.

10. Composant semi-conducteur émetteur de rayonnement selon l'une des revendications précédentes, **caractérisé en ce que** la couche réfléchissante (20) forme un contact ohmique avec la couche d'enveloppe (18) dopée positivement ou avec une autre couche semi-conductrice dopée positivement et disposée entre elle et la couche d'enveloppe (18).

11. Composant semi-conducteur émetteur de rayonnement selon l'une des revendications précédentes, **caractérisé en ce que** la structure stratifiée (12) est formée à partir d'un matériau semi-conducteur de liaison au nitrure-III-V.

12. Composant semi-conducteur émetteur de rayonnement selon la revendication 11, **caractérisé en ce que** la structure stratifiée (12) est formée à partir de InGaAlN.

13. Composant semi-conducteur émetteur de rayonnement selon l'une des revendications 1 à 10, **caractérisé en ce que** la structure stratifiée (12) est formée à partir d'un matériau semi-conducteur à composé de phosphure-III-V.

14. Composant semi-conducteur émetteur de rayonnement selon la revendication 13, **caractérisé en ce que** la structure stratifiée (12) est formée à partir d'InGaAIP.
